# EUROPÄISCHE PATENTSCHRIFT

(11) **EP 0 943 699 B1**
(45) Veröffentlichungstag und Bekanntmachung des Hinweises auf die Patenterteilung: **17.12.2003**
(21) Anmeldenummer: 98122354.8
(22) Anmeldetag: 25.11.1998
(51) Int. Cl.: C23C 14/56

(54) **Schleuseneinrichtung zum Ein- und/oder Ausbringen von Substraten in und/oder aus einer Behandlungskammer**
Load-lock device for transferring substrates in and out of a treatment chamber
Dispositif de sas pour le chargement et déchargement des substrats d'une chambre de traitement

(30) Priorität: 19.02.1998 DE 19807031; 19.02.1998 DE 29802947 U
(43) Veröffentlichungstag der Anmeldung: 22.09.1999
(73) Patentinhaber: Applied Films GmbH & Co. KG, 63755 Alzenau (DE)
(72) Erfinder: Baumecker, Tomas, 63486 Bruchköbel (DE); Grimm, Helmut Dr., 64291 Darmstadt (DE); Henrich, Jürgen, 63694 Limeshain (DE); Michael, Klaus Dr., 63571 Gelnhausen (DE); Rödling, Gert, 63179 Obertshausen (DE); Ulrich, Jürgen, 61137 Schöneck (DE)

(56) Entgegenhaltungen:
- EP-A- 0 816 529
- FR-A- 1 496 205
- US-A- 3 260 383
- US-A- 3 894 926
- PATENT ABSTRACTS OF JAPAN vol. 007, no. 272 (E-214), 3. Dezember 1983 & JP 58 153345 A (NIPPON DENSHI KK), 12. September 1983

## Beschreibung

Die Erfindung betrifft eine Schleuseneinrichtung zum kontinuierlichen Ein- und/oder Ausbringen von Werkstücken in und/oder aus atmosphärisch voneinander separierten Räumen mit mindestens einem die Räume verbindenden Schleusenkanal.

Gattungsgemäße Schleuseneinrichtungen sind z. B. aus der DE 27 47 061 A bekannt. Diese herkömmliche Schleuseneinrichtung dient dazu, endlose Trägerbänder, welche in einer Vakuumkammer zu beschichten sind, mittels der Schleusenvorrichtung vom umgebenden, Normaldruck aufweisenden Außenraum in die Beschichtungskammer einzubringen bzw. nach erfolgtem Beschichtungsprozeß aus der Beschichtungskammer herauszuführen. Der Druckunterschied zwischen dem atmosphärischen Außendruck und dem für vakuumgestützte Beschichtungsprozesse üblichen Vakuumdruck von maximal 10⁻³ mbar wird über eine Druckstufenstrecke aufrechterhalten, welche mehrere hintereinander angeordnete schlitzförmige Blenden aufweist, durch welche das Trägerband geführt wird. Wesentliche Elemente dieser sogenannten Bandschleusen, welche die Druckdifferenz gegenüber dem Druck in der eigentlichen Beschichtungskammer überbrücken, sind die als Schlitze oder Spalten ausgebildeten Blenden, welche der Luftströmung einen merklichen Widerstand entgegensetzen, so daß unter Einsatz von Vakuumpumpen die Erzeugung der gewünschten Druckdifferenz möglich ist. Um eine ausreichende atmosphärische Trennung zwischen dem Beschichtungsraum und dem Außenraum zu gewährleisten ist es erforderlich, die Blenden dem Profil des Trägerbandes anzupassen, um den Durchtritt von z. B. Luft in die Beschichtungskammer zu verhindern. Eine weitere Einschränkung einer derartigen Schleuseneinrichtung ist, daß das Trägerband selbst für die dichtende Funktion der Blenden notwendig ist, so daß es erforderlich ist, daß das Trägerband ausschließlich endlos durch die bekannte Schleuseneinrichtung transportiert werden kann, um einen Druckanstieg in der Beschichtungskammer zu vermeiden. Dies schränkt die Verwendung dieser bekannten Schleuseneinrichtung auf die durch eine Schleuse zu transportierenden Werkstücke nachteilig sehr stark ein.

Eine Karusselscheuse nach dem Oberbegriff des Anspruchs 1 wird durch die Druckschrift FR-1 496 205 A offenbart.

Der vorliegenden Erfindung liegt die Aufgabe zugrunde, eine gattungsgemäße Schleuseneinrichtung zu schaffen, die einen kontinuierlichen Transport von Werkstücken zwischen zwei Räumen ermöglicht, wobei die beiden Räume voneinander atmosphärisch getrennt sind, jedoch nicht die vorgenannten nachteiligen Einschränkungen aufweist.

Diese Aufgabe wird gemäß den Merkmalen des Patentanspruchs 1 dadurch gelöst, daß die atmosphärisch voneinander separierten Räume mit einem Schleusenkanal verbunden sind, in welchem mindestens eine das zu schleusende Werkstück aufnehmende Schleusenkammer zwischen den Räumen verfahrbar angeordnet ist, und wobei die Schleusenkammer eine Öffnung zum Be- und Entladen der Werkstücke und mindestens eine Dichtungsvorrichtung aufweist, mittels welcher der Schleusenkammerinnenraum atmosphärisch von den benachbarten Räumen abgedichtet ist.

Die erfindungsgemäße Schleuseneinrichtung ist geeignet, die Werkstücke zwischen Räumen mit identischem Atmosphärendruck wie auch zwischen Räumen, welche unterschiedliche Atmosphärendrücke aufweisen, zu schleusen, wie im Patentanspruch 2 angegeben.

Ein Merkmal der Erfindung ist es, dass einer der Räume atmosphärischen Normaldruck und der andere Raum atmosphärischen Unterdruck aufweist. Da während des Ein- bzw. Ausschleusens der Werkstücke in bzw. aus dem Unterdruckraum der Unterdruck aufrecht erhalten bleibt, können die z. B. in dem Unterdruckraum durchgeführten, einen Vakuumdruck erfordernden Behandlungsprozesse kontinuierlich durchgeführt werden. Das Belüften und anschließende Evakuieren der Vakuumkammer, insbesondere zum Ein- und/oder Ausbringen der zu behandelnden Werkstücke ist erfindungsgemäß nicht erforderlich. Mit der erfindungsgemäßen Schleuseneinrichtung ist es somit möglich, die Werkstücke in effizienter Weise zeit- und kostengünstig in den unter einem vom Außenraum abweichende Atmosphärenbeschaffenheit aufweisenden Raum hinein bzw. aus diesem heraus zu transportieren.

In der Praxis wurde eine Vakuumbeschichtungskammer, welche einen Atmosphärenunterdruck von maximal 10⁻³ mbar während des Beschichtungsprozesses aufwies, erfolgreich mittels der erfindungsgemäßen Schleuseneinrichtung mit zu beschichtenden Werkstücken vom Normaldruck aufweisenden Außenraum beschickt bzw. mit den in der Vakuumbeschichtungskammer beschichteten Werkstücken (Substraten) entladen.

Die Schleuseneinrichtung besteht aus einer Karussellschleuse, welche im wesentlichen ein Karussellgehäuse und ein in dem Karussellgehäuse drehbar gelagertes Schleusenkammerrad umfaßt. In dem Schleusenkammerrad sind umfangsseitig einzelne Schleusenkammern eingelassen, deren einzelne Öffnungen in radialer Richtung zugänglich sind. Das den Schleusenkanal bildende Karussellgehäuse weist umfangsseitig Dichtungsvorrichtungen auf, die während des Schleusungstransports dichtend an der Innenwand des Schleusenkanals anliegen, wodurch die einzelnen Schleusenkammern voneinander und von den z. B. unterschiedliche Atmosphärendrücke aufweisenden Räumen atmosphärisch getrennt sind. Die einzelnen Schleusenkammern werden während ihres Übergangs vom Raum höheren Drucks zum Raum mit niedrigerem Atmosphärendruck druckmäßig über eine Druckstufe angepasst, um das Einbringen von in den Schleusenkammern mitgeführtem Atmosphärengas in die Vakuumkammer zu vermeiden. Hierzu ist vorgesehen, den Schleusenkanal mittels geeigneter Pumpen, z. B. Vakuumpumpen zu evakuieren. Dazu ist der Schleusenkanal über mehrere Saugstutzen an Vakuumpumpen angeschlossen. Die Auslegung der Vakuumpumpen ist so gewählt, daß der atmosphärische Druck in dem Schleusenkanal über den Transportweg der Substrate in die Vakuumkammer kontinuierlich oder stufenweise abnimmt oder ansteigt. Die einzelnen zueinander benachbarten Schleusenkammern weisen somit abhängig von ihrer Position unterschiedliche Drücke auf.

Die zwischen den Schleusenkammern und der Innenwand des Schleusengehäuses angeordneten Dichtvorrichtungen bestehen aus Schieberdichtelementen, welche auf dem Umfang des Schleusenkammerrades dichten, und aus Radialdichtungen, welche durchgehend und z. B. einstückig als Dichtungsband umlaufend am Schleusenkammerrad angeordnet sind und den Durchtritt von Atmosphärenluft in axialer Richtung des Schleusenkammerrades verhindern. Die Dichtungseinrichtung ist vorteilhaft als Trockendichtung ausgebildet, was die Verwendung von Schmierstoffen vermiedet. Hierzu wird vorgeschlagen, einzelne Schieber aus einem abriebfesten elastischen Kunststoff, z. B. aus Teflon zu verwenden.

Gemäß den Merkmalen des Patentanspruchs 2 sind zum Be- und/oder Entladen der Schleusenkammern Beladevorrichtungen vorgesehen, welche vorzugsweise diametral zueinander und benachbart zum Schleusenkammerrad in den atmosphärisch voneinander getrennten Räumen angeordnet sind. Diese Be-/Entladevorrichtungen weisen jeweils Greifvorrichtungen auf, die z. B. die unbehandelten Substrate zum Einschleusen in eine Behandlungskammer in die einzelnen Schleusenkammern befördern und welche die behandelten Substrate zum Ausschleusen in die einzelnen Schleusenkammern befördern.

Weiterhin wird gemäß Patentanspruch 3 vorgeschlagen, die erfindungsgemäße Schleuseneinrichtung zum Ein- und Ausschleusen von mittels eines Vakuumbeschichtungsprozesses zu beschichtenden Substraten in/aus eine(r) Beschichtungskammer, welche eine Beschichtungsquelle aufweist, einzusetzen. Als Beschichtungsquelle eignen sich bekannte Verdampferquellen und/oder Sputterkathodenquellen zur Erzeugung einer Wolke aus verdampftem und/oder zerstäubtem Beschichtungsmaterial zum Niederschlag auf die zu beschichtenden Substrate. Die Substrate bestehen aus Kunststoffbehältern, z. B. Flaschen, auf deren Außenwandung eine optisch transparente, jedoch für den Durchtritt von Gasen und/oder Flüssigkeiten undurchlässige Sperrschicht abgeschieden wird. Hierzu wird mittels der Verdampfungs- bzw. Sputterkathodenquelle siliziumhaltiges Quellenmaterial verdampft bzw. zerstäubt, welches mit einem Sauerstoff enthaltenden Reaktionsgas, welches in die Beschichtungskammer eingeleitet wird, reagiert und als SiO₂-Schicht auf den Kunststoffbehältern niederschlägt.

Die Erfindung wird nachfolgend anhand eines bevorzugten und in Figuren dargestellten Ausführungsbeispiels näher beschrieben. Es zeigen:
- Fig. 1: den Längsschnitt durch eine Schleuseneinrichtung mit benachbarter Behandlungskammer sowie mit schematisch dargestelltem Transportweg der Werkstücke in der Behandlungskammer,
- Fig. 2: die Schleuseneinrichtung gemäß Fig. 1 mit Schleusenkammerrad mit zugeordneten Beladevorrichtungen mit zwei beladenen Schleusenkammern,
- Fig. 3: die Darstellung gemäß Fig. 2 in einer weiter getakteten Transportmomentaufnahme des Schleusenkammerrades und der Beladeeinrichtungen,
- Fig. 4: die Darstellung gemäß Fig. 3 bei weitergetakteter Transportmomentaufnahme,
- Fig. 5: die Darstellung gemäß Fig. 4 bei weitergetaktetem Transportweg,
- Fig. 6: die Darstellung gemäß Fig. 5 bei weitergetaktetem Transportweg,
- Fig. 7: die Darstellung gemäß Fig. 6 bei weitergetaktetem Transportweg,
- Fig. 8: Schnittansicht gemäß der Schnittlinie S-S' durch die Karussellschleuse nach Fig. 1,
- Fig. 9: eine vergrößerte Darstellung eines Teilausschnittes des Umfangs des Schleusenkammerrades mit Dichtungsvorrichtung,
- Fig. 10: Schnittansicht entlang der Schnittlinie U-U' in Fig. 9 und
- Fig. 11: einen Ausschnitt des Schleusenkammerrades gemäß Fig. 2 in vergrößerter Darstellung mit Schleusenkammer und zugeordneten Dichtungsvorrichtungen.

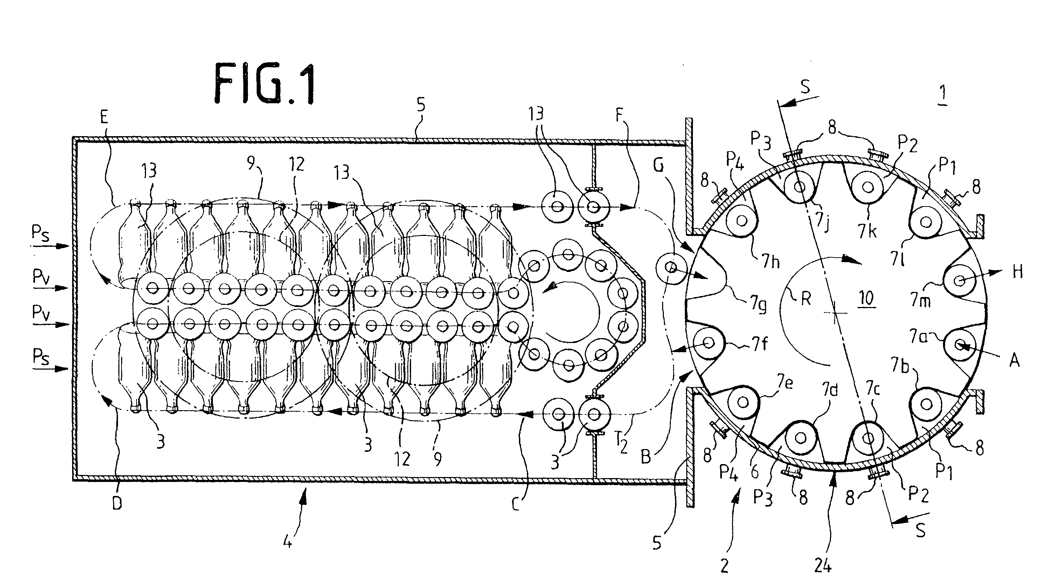

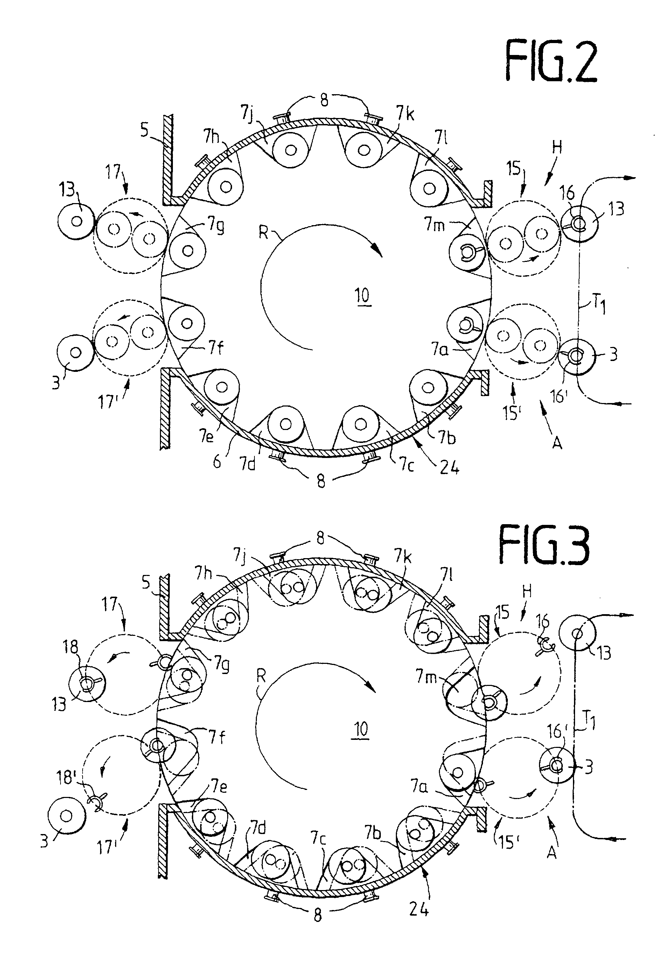

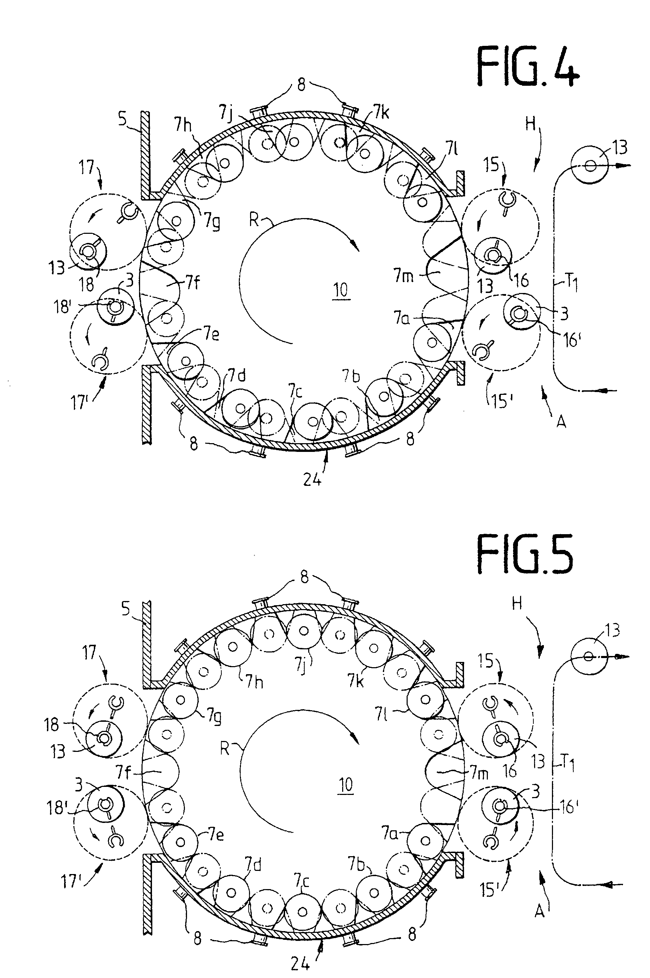

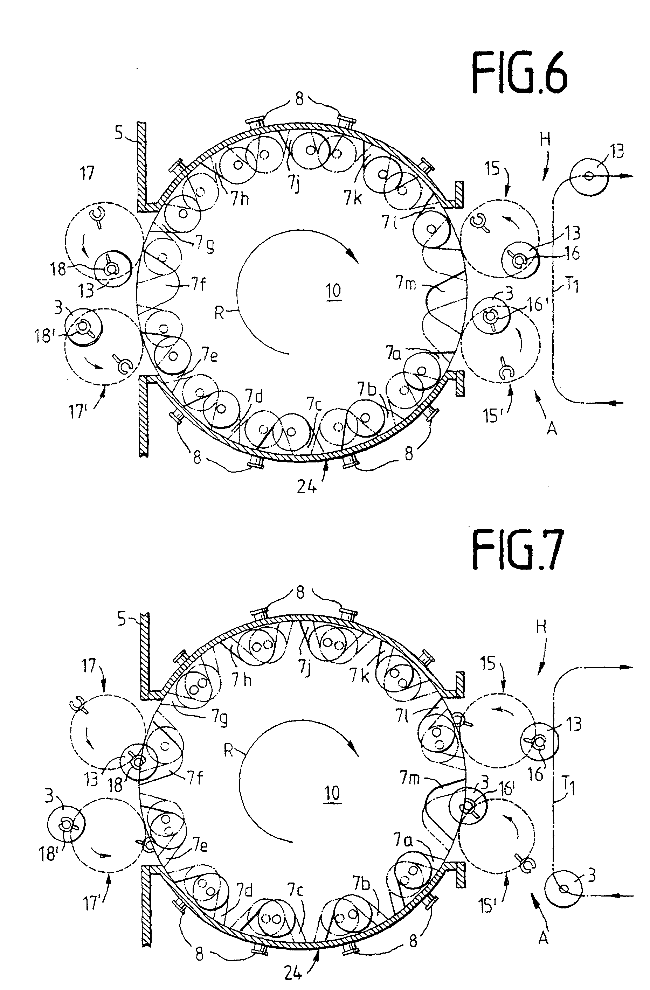

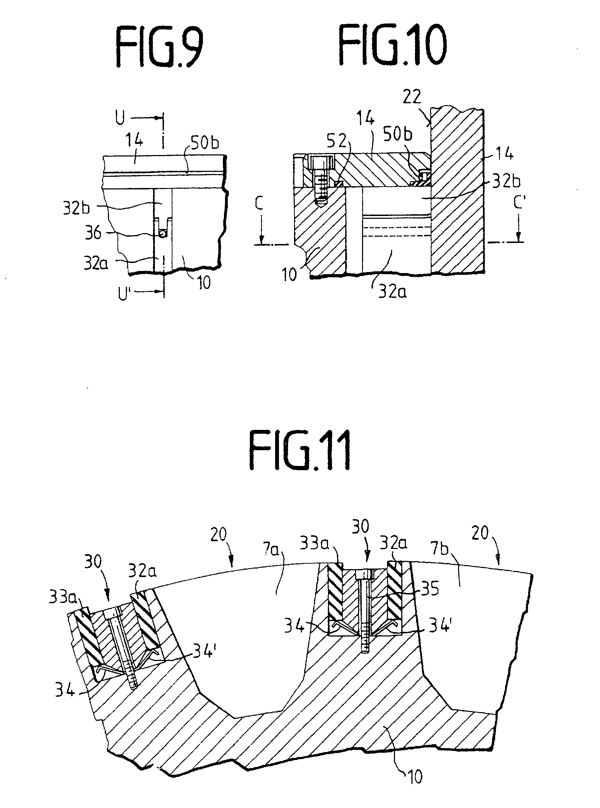

Die Schleuseneinrichtung 2 zum kontinuierlichen Ein- und/oder Ausbringen von Werkstücken in und/oder aus atmosphärisch voneinander separierten Räumen 1,4 besteht im wesentlichen aus einem als Karussellgehäuse 24 ausgebildeten Schleusenkanal 6, der einen Behandlungsraum 4 zum Bearbeiten der Substrate 3,13 mit dem Außenraum 1 verbindet. Die Schleuseneinrichtung 2 umfaßt neben dem Karussellgehäuse 24 ein in diesem drehbar gelagertes Schleusenkammerrad 10, in welchem umfangsseitig und äquidistant zueinander beabstandet einzelne Schleusenkammern 7a-7m eingelassen sind. Zum Einschleusen der Werkstücke 3 von dem Außenraum 1 in den Behandlungsraum 4 werden die einzelnen Werkstücke 3 in der in den Fig. 2-7 eingezeichneten Beschickungsstation A über den Transportweg T₁ (siehe Fig. 2) an die im Außenraum 1 angeordnete Beschickungsstation A herangeführt. Die Beschikkungsstation A umfaßt ein Übergabehandlung. 15', dem eine Greifvorrichtung 16' zugeordnet ist. Mittels der Greifvorrichtung 16' wird das über den Transportweg T₁ herangeführte Substrat 3 vorzugsweise endseitig ergriffen und durch eine gleichzeitig erfolgende, radial gerichtete Streckbewegung der Greifvorrichtung 16' und einer 180°-Drehung des Übergabehandlings 15' gegenüber einer leeren Schleusenkammer 7a positioniert. Das Substrat 3 wird dann durch eine in Richtung der Schleusenkammer 7a gerichtete Streckbewegung der Greifvorrichtung 16' durch die Schleusenkammeröffnung 20 (siehe Fig. 11) in die Schleusenkammer 7a eingebracht. Gleichzeitig wird ein beschichtetes Substrat 13 in analoger Weise, jedoch mit umgekehrtem Bewegungsablauf mittels des Übergabehandlings 15 und der zugeordneten Greifvorrrichtung 16 aus der Schleusenkammer 7m entnommen. Zum Transport der in die Schleusenkammern 7a-7m eingebrachten Substrate 3 bzw. 13 in Richtung der Vakuumkammer 4 bzw. in Richtung des Außenraums 1 dreht das Schleusenkammerrad 10 entsprechend der in den Fig. 1 bis 8 dargestellten Drehrichtung R. Zur Anpassung des Drucks in den Schleusenkammern 7a - 7m an den im Bereich der Übergabestationen A und H bzw. B und G ist die Karussellgehäuse 24 über radial verteilt angeordnete Saugstutzen 8 an nicht dargestellte Vakuumpumpen angeschlossen. Die Auslegung der einzelnen Pumpen ist derartig getroffen, daß die Drücke P₁, P₂, P₃, P₄ (siehe Fig. 1) in der Reihenfolge ihrer Aufzählung abnehmen. Da die einzelnen Schleusenkammern 7a-7m mittels Dichtungsvorrichtungen 30,32,33,34,35,36 atmosphärisch voneinander und gleichzeitig vom Außenraum 1 und von dem Behandlungsraum 4 vollständig getrennt sind, bilden jeweils sechs Schleusenkammern 7a - 7f bzw. 7g - 7m jeweils eine sogenannte Druckstufenstrecke, die das Eindringen von im Außenraum 1 herrschender Atmosphärenluft in die Behandlungskammer 4 wirksam unterdrückt und gleichzeitig den Transport von Substraten 3 bzw. 13 in bzw. aus der Behandlungskammer 1 in den Außenraum 4 ermöglicht bei konstantem Atmosphärendruck in der Behandlungskammer 4. Die in den Behandlungsraum 4 eingeschleusten Substrate 3 werden in analoger Weise wie bei der Beschickungsstation A bzw. der Entladestation H bei der Übergabestation auf ein in den Figuren nicht dargestelltes Transportband übergeben. Das Transportband durchläuft die Transportstrecke T₂, welche in Fig. 1 durch eine strichpunktierte Linie wiedergegeben ist. Die z. B. mittels einer schwenkbaren Haltevorrichtung an dem Transportband lösbar befestigten Substrate 3 werden entlang der Transportstrecke T₂ vor einzelnen Behandlungsstationen entlangbewegt.

Bei dem in Fig. 1 dargestellten Ausführungsbeispiel bestehen die Behandlungsstationen aus einzelnen, nicht dargestellten Beschichtungsquellen für die Vakuumbeschichtung. Diese Beschichtungsquellen, z. B. Verdampfungsquellen und/oder Kathodenzerstäubungsquellen, erzeugen in bekannter Art bezogen auf den Quellenmittelpunkt eine radialsymmetrische dreidimensionale Dichteverteilung 9 des verdampften bzw. zerstäubten Beschichtungsmaterials. Entsprechend der von den Prozeßparametern der Beschichtungsquelle und dem Beschichtungsmaterial abhängigen Emissionscharakteristik bilden sich sogenannte 25 %-Dichte- bzw. 50 %-Dichte-Verteilungen 9,12 aus, wie in Fig. 1 dargestellt.

Um eine gleichmäßige, homogene Beschichtung der Substrate 3,13 sowohl auf ihren äußeren Wandflächen als auch auf deren Bodenfläche zu gewährleisten, werden die Substrate 3,13 zunächst in einer Wandbeschichtungsposition schräg zu den vorzugsweise am Boden der Beschichtungskammer 4 angeordneten Beschichtungsquellen ausgerichtet. Während des Transports der Substrate 3,13 in der Wandbeschichtungsposition P_{S} werden die Substrate 3,13 um ihre Längsachse gedreht, um eine Rundumbeschichtung zu gewährleisten. Nach erfolgter Beschichtung der Wandflächen wendet die Transportstrecke T₂ um 180° mit einer in der Fig. 1 nicht dargestellten Wendeeinrichtung, wobei die Substrate 3,13 gleichzeitig von einer schrägen Beschichtungsposition P_{S} in eine vertikale Beschichtungsposition P_{V} überführt werden. Die mit ihrer Bodenfläche zu den Beschichtungsquellen ausgerichteten Substrate werden an den Beschichtungsquellen vorbeigeführt, wobei, wie in Fig. 1 dargestellt, die Substrate 3,13 nunmehr oberhalb der gleichzeitig in der Wandbeschichtungsposition P_{S} befindlichen Substrate 3,13 beschichtet werden. Nach Durchlaufen der Transportstrecke T₂ in der Bodenbeschichtungsposition P_{V} werden die Substrate 3,13 durch eine Wendevorrichtung 11 parallel, jedoch entgegengesetzt zur ersten Bodenbeschichtungsposition P_{V} an den Beschichtungsquellen in einer weiteren Bodenbeschichtungsposition P_{V} entlangbewegt. Im Anschluß an diese Beschichtungsphase wendet der Transportweg abermals um 180°, woran sich eine abschließende Beschichtungsphase, die die Substrate 3 nunmehr in einer Wandbeschichtungsposition P_{S} durchlaufen, anschließt.

Die beschichteten Substrate 13 werden durch das Transportband entlang der Transportstrecke T₂ zur Übergabestation G transportiert. Nach der Übergabe der Substrate 13 in die Schleusenkammern 7a - 7m des Schleusenkammerrades 10 werden die beschichteten Substrate 13 durch Drehung des Schleusenkammerrades 10 in Drehrichtung R zur Entladestation H verfahren, wo sie in der oben geschilderten Weise mittels des in den Fig. 2 bis 7 dargestellten Übergabehandlings 15 und der Greifvorrichtung 16 der Transportstrecke T₁ zugeführt werden (siehe Fig. 2).

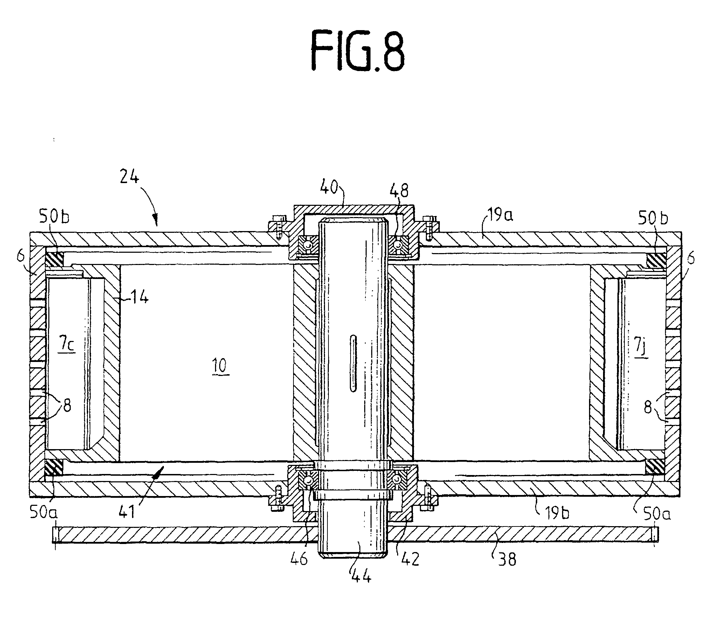

Die Ausbildung der Schleuseneinrichtung 2 als Karussellschleuse ist der Fig. 8 zu entnehmen. Die Schleuseneinrichtung 2 besteht im wesentlichen aus dem Karussellgehäuse 24, in welches das Schleusenkammerrad 10 auf einer Welle 44 drehbar angeordnet ist. Die Welle 44 wird mittels zwei in Lagergehäusen 40 bzw. 42 eingepaßten Lagern 48 bzw. 46 gehalten. In dem Schleusenkammerrad 10 sind einzelne, jeweils diametral gegenüberliegende und äquidistant zueinander beabstandete, über den Umfang des Schleusenkammerrades 10 angeordnete Schleusenkammern 7a - 7m ausgebildet. Wie der Fig. 8 zu entnehmen ist, sind die Schleusenkammern 7c bzw. 7j stellvertretend für die übrigen Schleusenkammern mittels Dichtungsvorrichtungen 34,34',36, 32a,32b,50a,50b gegenüber dem Schleusenkanal 41 atmosphärisch druckdicht, insbesondere vakuumdicht, vorzugsweise hochvakuumdicht getrennt. Die Dichtungsvorrichtungen 34,34',36,32a,32b,50a,50b bestehen aus jeweils ober- und unterhalb der einzelnen Schleusenkammern 7c zw. 7j ausgebildeten Radialdichtungen 50a,50b, die, wie in den Fig. 9 und 10 abgebildet, gegenüber der Schleusenkanalinnenwand 22 einerseits und Schiebern 32b, die fest mit dem Schleusenkammerrad 10 und benachbart zu den Schleusenkammern 7a-7m angeordnet sind, andererseits atmosphärisch dichten. Der Schieber 32b wird in einer in einem zugeordneten Schieber 32a ausgebildeten Kulisse geführt, wobei mittels eines elastisch verformbaren Ausgleichselements 36 zwischen dem Schieber 32b und dem Schieber 32a diese federnd dichtend in Kontakt gehalten werden. Die Schieber 32a bzw. 32b werden in radialer Richtung durch Federelemente 34,34' (siehe Fig. 11), welche durch eine Schraube 35 in dem Schleusenkammerrad 10 fixiert sind, radial nach außen gedrückt, wodurch die Schieber 32a,32b auch bei Drehung des Schleusenkammerrades 10 in dynamischem dichtendem Kontakt mit der Schleusenkammerinnenwand 22 gehalten werden. Durch die Dichtungsvorrichtung 34,34',36,32a,32b,50a,50b ist somit gewährleistet, daß die einzelnen Schleusenkammern 7a,7b,... während des Schleusungsvorganges atmosphärisch und ausreichend vakuumdichtend voneinander getrennt sind.

### Bezugszeichenliste

- 1: Raum, Außenraum
- 2: Schleuseneinrichtung
- 3: Substrat, Behälter, Werkstück
- 4: Raum, Behandlungsraum, Beschichtungskammer
- 5: Kammerwand
- 6: Schleusenkanal
- 7a-7m: Schleusenkammer
- 8: Pumpöffnungen, Saugstutzen
- 9: Bedampfungswolke, 25 %-Dichteverteilung
- 10: Karussellrad, Schleusenkammerrad
- 11: Wendevorrichtung
- 12: Bedampfungswolke, 50 %-Dichteverteilung
- 13: Substrat, beschichtet
- 14: Schleusenkammerwand
- 15,15': Übergabehandling
- 16,16': Greifvorrichtung
- 17,17': Übergabehandling
- 18,18': Greifvorrichtung
- 19a,b: Schleusendeckel, Schleusenboden
- 20: Schleusenkammeröffnung
- 22: Schleusenkanalinnenwandung
- 24: Karussellgehäuse
- 30,30': Dichtungsvorrichtung
- 32a,b: Schieber
- 33a,b: Schieber
- 34: Federelement
- 35: Schraube
- 36: Ausgleichselement
- 38: Zahnrad
- 40: Lagerdeckel
- 41: Schleusenkanal
- 42: Lagerdeckel
- 44: Welle
- 46: Lager
- 48: Lager
- 50a,b: Radialdichtung
- 52: Dichtelement
- 60: Beschichtungsquelle

- A: Beschickungsstation
- B: Übergabestation
- C, D, E, F: Transportweg
- G: Übergabestation
- H: Entladestation
- R: Drehrichtung
- P_{S}: Behälterwandbeschichtungsposition
- Pᵥ: Behälterbodenbeschichtungsposition
- T₁: Transportstrecke / Außenraum
- T₂: Transportstrecke / Innenraum

## Patentansprüche

1. Karussellschleuse zum kontinuierlichen Ein- und/oder Ausbringen von Werkstücken (13) in und/oder aus einem Vakuumbeschichtungsraum (4) in einen Raum (1) mit Atmosphärendruck mit mindestens einem die Räume (1, 4) verbindenden Karussellgehäuse (24, 41), in welchem ein Schleusenkammerrad (10) drehbar gelagert ist, welches umfangseitig in den umlaufenden Seitenrand des Schleusenkammerrades (10) eingelassene Schleusenkammern (7a - 7m) mit einer Öffnung (20) zum Be- und Entladen des Schleusenkammerrades (10) mit zu schleusenden Werkstücken (13) aufweist, wobei die Schleusenkammern (7a - 7m) mindestens eine Dichtungsvorrichtung (30) aufweisen, mittels welcher in Zusammenwirken mit der Innenwandung (22) des Karussellgehäuses (24) der Innenraum der Schleusenkammern (7a - 7m) atmosphärisch von den Räumen (1, 4) während des Schleusendurchtritts abgedichtet ist und das Karussellgehäuse (24, 41) einen Saugstutzen (8) zum Evakuieren der Schleusenkammern (7a - 7m) aufweist, **dadurch gekennzeichnet, dass** die Dichtungsvorrichtung (30) am Schleusenkammerrad (10) vorgesehen ist und dichtend an der Innenwandung (22) des Karussellgehäuses (24) anliegt, dass das Karussellgehäuse (24, 41) über seinen Umfang verteilt mehrere Saugstutzen (8) aufweist und dadurch als differentiale Druckstufe ausgebildet ist, wobei der Druck in dem Karussellgehäuse (24, 41) zwischen der Innenwandung (22) des Karussellgehäuses (24) und dem Schleusenkammerrad (10) ausgehend von einer Beschickungsstation (A) bzw. einer Entladestation (H) im äußeren Raum (1) umlaufend in Richtung der Übergabestation (B) bzw. einer Übergabestation (G) von dem im äußeren Raum (1) herrschenden atmosphärischen Druck auf den in dem inneren Raum (4) herrschenden Druck abnimmt.

2. Schleuseneinrichtung nach Anspruch 1, **dadurch gekennzeichnet, daß** zum Beladen und/oder Entladen des Schleusenkammerrades (10) mit den Substraten (3,13) Beladevorrichtungen (15,15'; 17,17') vorgesehen sind, welche mittels Greifvorrichtungen (16,16'; 18,18') die unbehandelten Substrate (3) bzw. die behandelten Substrate (13) in die Schleusenkammer (7a-7m) bzw. aus der Schleusenkammer (7a-7m) befördern.

3. Schleuseneinrichtung nach mindestens einem der Ansprüche 1 bis 2, **dadurch gekennzeichnet, daß** in der Vakuumbeschichtungsraum (4) mindestens eine Beschichtungsquelle, vorzugsweise eine Verdampferquelle und/oder eine Sputterkathodenquelle zur Erzeugung einer Wolke aus verdampftem und/oder zerstäubtem Beschichtungsmaterial zum Niederschlag auf die zu beschichtenden Substrate (3,13) vorgesehen ist, und wobei die Substrate (3,13) vor der Beschichtungsquelle verfahrbar angeordnet sind.

## Claims

1. A carousel-type lock for continuous introduction and/or removal of workpieces (13) into and/or out of a vacuum-coating space (4) in a space (1) with atmospheric pressure, with at least one carousel housing (24, 41) connecting the spaces (1, 4), in which a lock-chamber wheel (10) is supported in rotatable manner which on the periphery exhibits lock chambers (7a - 7m) which are recessed into the circumferential side edge of the lock-chamber wheel (10), with an opening (20) for loading and unloading the lock-chamber wheel (10) with workpieces (13) to be transferred through the lock, the lock chambers (7a - 7m) exhibiting at least one sealing mechanism (30), by means of which, in common action with the inner wall (22) of the carousel housing (24), the inner space of the lock chambers (7a - 7m) is sealed off atmospherically from the spaces (1,4) during the passage through the lock, and the carousel housing (24, 41) exhibiting a suction nozzle (8) for evacuating the lock chambers (7a - 7m), **characterised in that** the sealing mechanism (30) is provided on the lock-chamber wheel (10) and abuts the inner wall (22) of the carousel housing (24) in sealing manner, **in that** the carousel housing (24, 41) exhibits several suction nozzles (8) distributed over its periphery and as a result takes the form of a differential pressure stage, whereby the pressure in the carousel housing (24, 41) between the inner wall (22) of the carousel housing (24) and the lock-chamber wheel (10), proceeding from a charging station (A) or an unloading station (H) in the outer space (1) circumferentially in the direction of the transfer station (B) or a transfer station (G), decreases from the atmospheric pressure prevailing in the outer space (1) to the pressure prevailing in the inner space (4).

2. Lock device according to Claim 1, **characterised in that** for the purpose of loading and/or unloading the lock-chamber wheel (10) with the substrates (3,13) loading mechanisms (15,15'; 17,17') are provided which by means of gripping mechanisms (16,16'; 18,18') convey the untreated substrates (3) and the treated substrates (13) into the lock chamber (7a-7m) and out of the lock chamber (7a-7m), respectively.

3. Lock device according to at least one of Claims 1 to 2, **characterised in that** at least one coating source, preferably an evaporator source and/or a sputtering-cathode source for generating a cloud consisting of evaporated and/or sputtered coating material to be deposited onto the substrates (3,13) to be coated, is provided in the vacuum-coating space (4), the substrates (3,13) being arranged so as to be capable of being displaced in front of the coating source.

## Revendications

1. Sas à carrousel pour l'amenée et/ou l'évacuation en continu de pièces à oeuvrer (13) vers et/ou depuis un compartiment de revêtement sous vide (4) jusque dans un compartiment (1) à pression atmosphérique, avec au moins un carter de carrousel (24, 41) qui relie les compartiments (1, 4) et dans lequel une roue de chambre à sas (10) est montée mobile en rotation et présente sur la circonférence dans son rebord latéral circonférentiel des chambres à sas encastrées (7a - 7m) avec une ouverture (20) pour charger et décharger la roue de chambre à sas (10) avec des pièces à écluser (13), les chambres à sas (7a - 7m) comportant au moins un dispositif d'étanchéité (30) à l'aide duquel, en coopération avec la paroi intérieure (22) du carter de carrousel (24), le compartiment intérieur des chambres à sas (7a - 7m) est étanché sur le plan atmosphérique vis-à-vis des compartiments (1, 4) pendant la traversée du sas et le carter de carrousel (24, 41) comportant une tubulure d'aspiration (8) pour évacuer les chambres à sas (7a - 7m), **caractérisé en ce que** :
- le dispositif d'étanchéité (30) est prévu sur la roue de chambre à sas (10) et vient en contact avec étanchéité contre la paroi intérieure (22) du carter de carrousel (24) ; et
- le carter de carrousel (24, 41) comporte plusieurs tubulures d'aspiration (8) réparties sur sa circonférence et est, par conséquent, réalisé comme étage de pression différentiel, la pression dans le carter de carrousel (24, 41), entre la paroi intérieure (22) du carter de carrousel (24) et la roue de chambre à sas (10), diminuant en partant d'une station d'alimentation (A) ou d'une station de décharge (H) dans le compartiment extérieur (1) sur tout le tour, en direction de la station de transmission (B) ou d'une station de transmission (G), de la pression atmosphérique qui règne dans le compartiment extérieur (1) jusqu'à la pression qui règne dans le compartiment intérieur (4).

2. Dispositif à sas selon la revendication 1, **caractérisé en ce que**, pour le chargement et/ou le déchargement des substrats (3, 13) dans la roue de chambre à sas (10), il est prévu des dispositifs de chargement (15, 15' ; 17, 17') qui, à l'aide de dispositifs de préhension (16, 16' ; 18, 18'), convoient les substrats non traités (3) ou les substrats traités (13) vers les chambres à sas (7a - 7m) ou depuis les chambres à sas (7a - 7m).

3. Dispositif à sas selon l'une ou l'autre des revendications 1 et 2, **caractérisé en ce que**, dans le compartiment de revêtement sous vide (4), il est prévu au moins une source de revêtement, de préférence une source de vaporisation et/ou une source à cathode de pulvérisation pour générer un nuage de matériau de revêtement vaporisé et/ou pulvérisé destiné à se précipiter sur les substrats à revêtir (3, 13) et les substrats (3, 13) étant agencés mobiles en translation devant la source de revêtement.
